# EUROPÄISCHE PATENTSCHRIFT

(11) **EP 0 963 687 B1**
(45) Veröffentlichungstag und Bekanntmachung des Hinweises auf die Patenterteilung: **26.09.2001**
(21) Anmeldenummer: 98912394.8
(22) Anmeldetag: 25.02.1998
(51) Int. Cl.: H05K 3/00, B41F 15/08, B05C 1/08, B05C 9/04

(54) **AUFTRAGSVORRICHTUNG ZUM AUFTRAGEN VON LÖTSTOPP-LACK AUF BEIDE SEITEN EINER LEITERPLATTE**
COATING DEVICE FOR COATING SOLDER RESIST ON BOTH SIDES OF A PRINTED CIRCUIT BOARD
SYSTEME D'ENDUCTION POUR L'APPLICATION DE LAQUE DE FIN DE BRASAGE SUR DEUX FACES D'UNE PLAQUETTE DE CIRCUIT IMPRIME

(30) Priorität: 25.02.1997 DE 29703356 U
(43) Veröffentlichungstag der Anmeldung: 15.12.1999
(73) Patentinhaber: P.A.C. Circuiti Stampati S.R.L., 37050 Angiari (IT)
(72) Erfinder: BEZZETTO, Sandro, I-37050 Cerea (IT)
(74) Vertreter: Grünecker, Kinkeldey, Stockmair & Schwanhäusser Anwaltssozietät
(86) Internationale Anmeldenummer: EP9801074
(87) Internationale Veröffentlichungsnummer: WO9838842

(56) Entgegenhaltungen:
- EP-A- 0 392 625
- WO-A-95/11581
- DE-A- 19 704 260

## Beschreibung

Die Erfindung betrifft eine Auftragsvorrichtung zum Auftragen von zumindestens Lötstopp-Lack auf beide, insbesondere mit strukturierten Leiterbahnen versehene Seiten einer Leiterplatte mit wenigstens zwei einer Plattenseite zuordbaren und drehbar gelagerten Auftragskörpern.

Eine solche Auftragsvorrichtung ist aus dem Document DE 19704260 bekannt.

Bei einer solchen aus einer Praxis bekannten Auftragsvorrichtung wird beispielsweise durch zwei Druckwalzen mit auf ihrer Außenseite aufgetragenem Lötstopp-Lack eine Plattenober- und -unterseite beschichtet. Die Beschichtung mit dem Lötstopp-Lack dient zum Schutz aller Teile auf der Leiterplatte, außer denen, in denen elektrische oder elektronische Bauteile aufgelötet werden sollen.

Nachteilig bei der bekannten Auftragsvorrichtung ist, daß die Arbeitsgeschwindigkeit mit den Druckwalzen relativ gering ist und gleichzeitig die Herstellung der Druckwalzen sowie das Auftragen von Lötstopp-Lack auf einem Außenumfang der Walzen relativ aufwendig und schwierig ist. Außerdem ist die Dicke der aufgetragenen Lötstopp-Lackschicht nur relativ schwer zu steuern.

Der vorliegenden Erfindung liegt daher die Aufgabe zugrunde, eine Auftragsvorrichtung der eingangs genannten Art so zu verbessern, daß diese einfacher im Aufbau ist und gleichzeitig schneller und gut reproduzierbar, insbesondere Lötstopp-Lack gleichzeitig auf beide Seiten einer Leiterplatte aufträgt.

Diese Aufgabe wird dadurch gelöst, daß die Auftragskörper zwei beidseitig zu einem im wesentlichen horizontalen Transportweg der Leiterplatte angeordnete Siebdrucktrommeln sind, wobei eine Transporteinrichtung Transportbänder entlang des Transportweges aufweist und die Transporteinrichtung weiterhin auf einer Plattenseite aufdrückbare Andrückeinrichtungen zum Halten der Leiterplatte auf den Transportbändern aufweist.

Durch die beidseitige Anordnung der Auftragskörper erfolgt das gleichzeitige Auftragen von insbesondere Lötstopp-Lack. Durch den horizontalen Transportweg ergibt sich eine optimale Haftung des Lötstopp-Lackes auf den Plattenseiten, wobei durch Verwendung der Siebdrucktrommein gleichzeitig ein gleichmäßiger und konstanter Auftrag der Beschichtung auf beiden Seiten der Leiterplatte erfolgen kann. Durch die Verwendung der Siebdrucktrommeln ist außerdem eine hohe Beständigkeit beim Auftragen möglich, wobei die erfindungsgemäße Auftragsvorrichtung gleichzeitig einfacher aufgebaut und einsetzbar ist und entsprechend preiswerter als die vorbekannte Auftragsvorrichtung mit Druckwalzen ist.

Aufgrund des gleichzeitigen, gleichmäßigen und konstanten Auftragens, insbesondere von Lötstopp-Lack, können aus den beiden Seiten der Leiterplatte gleichzeitig und in gleicher Zeit getrocknet werden, so daß sich keine unterschiedliche Empfindlichkeiten bei der darauffolgenden Belichtung und entsprechenden Entwicklung zur weiteren Strukturierung der Leiterplattenseiten ergeben.

Durch den im wesentlichen horizontalen Transportweg können außerdem bekannte und bereits bewährte Einrichtungen zur Zufuhr und zur Entnahme zu und von den Siebdrucktrommeln eingesetzt werden. Dadurch werden die Kosten der Auftragsvorrichtung weiter reduziert.

Um die Leiterplatten in einfacher Weise zu transportieren und zu halten, weist die Transporteinrichtung entlang des Transportweges verlaufende Transportbänder auf sowie auf eine Plattenseite aufdrückbare Andrückeinrichtungen zum Halten der Leiterplatte auf den Transportbändern. Vorzugsweise drücken die Andrückeinrichtungen auf eine Plattenoberseite gegenüberliegend zu den Transportbändern auf.

Zur Verwendung von Leiterplatten unterschiedlicher Abmessungen und insbesondere unterschiedlicher Dicken, und für verbesserte Zugängigkeit der Siebdrucktrommeln zur Reparatur, Reinigung oder dergleichen, kann wenigstens eine Siebdrucktrommel im wesentlichen senkrecht zur Transportrichtung verstellbar gelagert sein. Bei verstellbarer Lagerung nur einer Siebdrucktrommel wird der Aufbau der Auftragsvorrichtung weiterhin vereinfacht.

Die Leiterplatten werden zudem von den beiden Siebdrucktrommeln gebildeten Druckspalt entlang ihres im wesentlichen horizontalen Transportweges transportiert. Um Plattenober- und -unterseiten möglichst vollständig bedrucken zu können, kann der horizontale Transportweg durch die zumindest Randbereiche oder Ränder der Leiterplatte abstützen und/oder haltende Transporteinrichtung bestimmt sein. Aufgrund des geringen Gewichts der Leiterplatte ist es beispielsweise ausreichend, in eine entsprechende Transporteinrichtung von außen auf die gegenüberliegenden und parallel zur Transporteinrichtung liegenden Ränder der Leiterplatte aufdrückt und die Leiterplatte bewegt. Ebenso kann die Transporteinrichtung in einem schmalen Randbereich der Leiterplaate auf Plattenober- und -unterseite angreifen, solange in diesem Randbereich kein Auftragen von beispielsweise Lötstopp-Lack erfolgen muß. Weiterhin können Transporteinrichtungen für Randbereiche und Rand der Leiterplatte in Kombination gleichzeitig oder hintereinander entlang des Transportweges eingesetzt werden.

Weitere Möglichkeiten zur Transporteinrichtung und deren Kombination sind offensichtlich.

Eine Transporteinrichtung kann beispielsweise durch auf einen Außenrand der Leiterplatte andrückende Transporträder gebildet werden. Weiterhin kann die Transporteinrichtung entlang des Transportweges Transportbänder aufweisen, auf denen die Randbereiche der Leiterplatte aufliegen und/oder die an dem Außenrand der Leiterplatte andrücken.

Weitere Möglichkeiten für Transporteinrichtungen und deren Kombination sind offensichtlich.

Bei Randbereichen auf der Plattenunterseite zugeordneten Transportbänder kann es sich als vorteilhaft erweisen, wenn zur positionsgenauen, mit der Drehung der Siebdrucktrommel synchronisierten Zufuhr, die Transporteinrichtung auf die Plattenoberseite aufdrückbare Andrückeinrichtungen zum Halten der Leiterplatte auf den Transportbändern aufweist.

Solche Andrückeinrichtungen können beispielsweise einen Randbereich der Plattenoberseite zuordbare Andrückelemente sein. Weiterhin kann die Andrückeinrichtung Andrückrollen aufweisen, die sich beispielsweise über die gesamte Breite der Leiterplatte senkrecht zur Transportrichtung erstrecken können. Solche Andrückeinrichtungen sind zumindest entlang des die Leiterplatten zu den Siebdrucktrommeln hinführenden Transportweges angeordnet. Bei entsprechender Ausbildung oder Anordnung der Andrückeinrichtungen können diese auch entlang des Transportweges angeordnet sein, der zum Abtransportieren der Leiterplatten von den Siebdrucktrommeln dient. Dabei muß nur sichergestellt werden, daß die Andrückeinrichtungen den beispielsweise aufgetragenen Lötstopp-Lack nicht abtragen oder dieser bereits vorher getrocknet ist. Dazu kann eine entsprechende Trocknungseinrichtung beispielsweise direkt entlang des Transportweges den Siebdrucktrommeln nachgeordnet sein.

Bevorzugt können die Andrückrollen verschwenkbar gelagert sein, wobei sie beispielsweise federbeaufschlagt auf die Plattenoberseite andrückbar sind. Die Lagerung der Andrückrollen erfolgt vorzugsweise seitlich zum Transportweg.

Um auf eine größere Anzahl von Leiterplatten in gleicher oder auch anderer Weise Lötstopp-Lack aufzutragen, können mehrere Transportwege für Leiterplatten nebeneinander zur parallelen Zufuhr von Leiterplatten zu den Siebdrucktrommeln ausgebildet sein. Dabei können die Siebdrucktrommeln im Bereich der verschiedenen Transportwege gleichartig ausgebildet sein, so daß jede der parallel zugeführten Leiterplatten gleichartig mit Lötstopp-Lack versehen werden. Ebenso können die Siebdrucktrommeln entlang ihrer Drehachse unterschiedlich für jeden Transportweg ausgebildet sein, so daß gleichzeitig verschiedene Muster von Lötstopp-Lack auf parallel zugeführte Leiterplatten auftragbar sind. Ebenso können die parallel den Siebdrucktrommeln zugeführten Leiterplatten beispielsweise mit gleichem Auftrag auf der Plattenoberseite und unterschiedlichen Aufträgen auf der Plattenunterseite und umgekehrt versehen werden. Außerdem ist es möglich, jede Leiterplatte -einseitig oder beidseitig mit einer Siebdrucktrommel mehrfach hintereinander zu bedrucken.

Zur einfachen Höhenverstellung der wenigstens einen Siebdrucktrommel kann eine Höhenverstelleinrichtung zur automatischen Höhenverstellung zugeordnet sein. Auf diese Weise kann per "Knopfdruck" die verstellbare Siebdrucktrommel relativ zur anderen Siebdrucktrommel angehoben oder abgesenkt werden.

Im einfachsten Fall kann die Höhenverstelleinrichtung eine Höhenanzeigeeinrichtung und einen Antrieb zum Anheben und Absenken aufweisen. Die Höhenanzeigeeinrichtung kann beispielsweise eine Skala sein, an der die jeweilige Höhenposition der verstellbaren Siebdrucktrommel ablesbar ist. Der Antrieb kann beispielsweise ein von einem Motor angetriebenes Zahnrad aufweisen, das entlang einer im wesentlichen vertikal angeordneten Zahnstange abrollt. Weitere Antriebe sind einfach realisierbar.

Um die Auftragsvorrichtung weiterhin zu vereinfachen, kann beiden Siebdrucktrommeln eine Antriebseinrichtung zugeordnet sein. Eine solche Antriebseinrichtung kann beispielsweise einen mit einer Siebdrucktrommel antriebsverbundenen Motor und einen Antriebsriemen zwischen den beiden Siebdrucktrommeln zur Übertragung der Drehung auf die andere Siebdrucktrommel aufweisen. Bevorzugt weist die Antriebseinrichtung einen Motor und einen Geschwindigkeitsregler zur Synchronisierung der Drehungen der Siebdrucktrommein auf. Auf diese Weise ist sichergestellt, daß der Lötstopp-Lack in korrekter Weise von Anfang bis Ende entlang der Leiterplatten auf deren Ober- und Unterseiten aufgetragen wird.

Um beispielsweise in einfacher Weise unterschiedlich große Leiterplatten und/oder unterschiedliche Muster von Lötstopp-Lack beidseitig auf Leiterplatten auftragen zu können, ist es günstig, wenn die Siebdrucktrommeln austauschbar in der Auftragsvorrichtung gelagert sind. Dadurch können beispielsweise Siebdrucktrommeln unterschiedlicher Durchmesser oder mit unterschiedlichen Matrizen verwendet werden.

Um den Betrieb der Auftragsvorrichtung zu automatisieren und für den Benutzer zu vereinfachen, kann die Auftragsvorrichtung eine Steuerelektronik mit zumindest einem Mikroprozessor und einer Speichereinrichtung aufweisen. Durch die Steuerelektronik sind unterschiedliche Auftragsprogramme abrufbar, wobei beispielsweise auch Unterschiede in den Matrizen verschiedener einbaubarer Siebdrucktrommeln in der Speichereinrichtung gespeichert sein können. Nach Austausch einer Siebdrucktrommel kann mittels der Steuerelektronik beispielsweise automatisch ein entsprechendes Auftragsprogramm für unterschiedlich große Leiterplatten oder für eine andere Matrize abgerufen werden.

Zur vereinfachten Lagerung der Siebdrucktrommeln in der Auftragsvorrichtung und zur vereinfachten Zufuhr von aufzutragendem Material, insbesondere Lötstopp-Lack, kann jede Siebdrucktrommel in einer Halterung drehbar gelagert sein, an welcher weiterhin eine einem Innenumfang der Siebdrucktrommel zuordbare Spende- und Auftragseinrichtung verstellbar gelagert ist. Die Spende- und Auftragseinrichtung kann einen Tank oder dergleichen für das aufzutragende Material enthalten, aus dem das Material mengenmäßig dosiert über eine Spendeeinrichtung ausgegeben und mittels der Auftragseinrichtung auf eine Innenseite der Matrize der Siebdrucktrommeln auftragbar ist.

Im folgenden wird ein vorteilhaftes Ausführungsbeispiel der Erfindung anhand der in der Zeichnung beigefügten Fig. näher erläutert und beschrieben.

Es zeigen:
- Fig. 1: eine Seitenansicht einer erfindungsgemäßen Auftragsvorrichtung, und
- Fig. 2: eine Draufsicht auf die Auftragsvorrichtung nach Fig. 1.

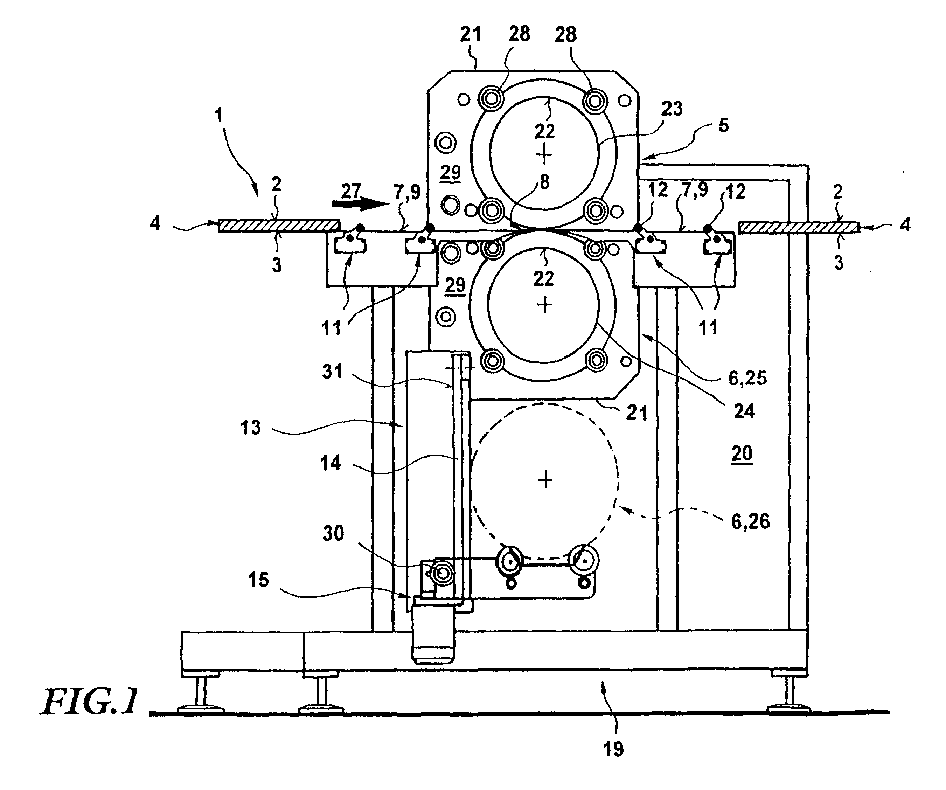

In Fig. 1 ist eine Seitenansicht der erfindungsgemäßen Auftragsvorrichtung 1 dargestellt.

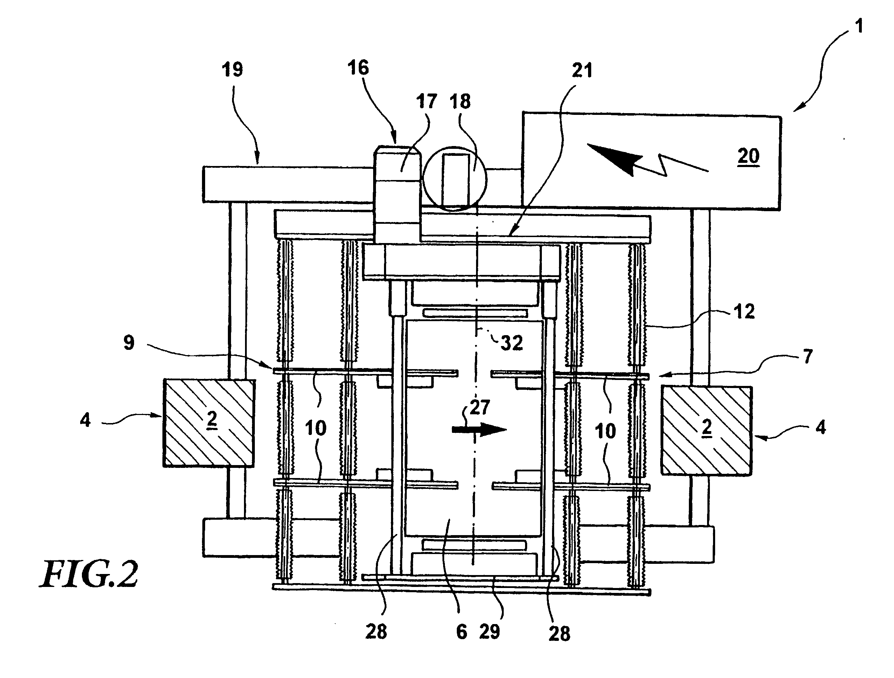

Die Auftragsvorrichtung 1 weist einen Vorrichtungsrahmen 19 auf, der mittels höhenverstellbarer Füße auf einem Untergrund aufgestellt ist. In dem Vorrichtungsrahmen sind als Auftragskörper zwei Siebdrucktrommeln 5, 6 drehbar gelagert. Zur Lagerung der Siebdrucktrommeln 5, 6 dient eine Halterung 21 mit zumindest einseitig in Axialrichtung der Siebdrucktrommel angeordneten Halteplatten 29 und diese mit einer Antriebseinrichtung 16, siehe Fig. 2, verbindenden Haltestäben 28.

Die beiden Siebdrucktrommeln 5, 6 begrenzen einen Druckspalt 8 und sind beidseitig zu einem im wesentlichen horizontalen Transportweg 7 angeordnet, der durch eine Transporteinrichtung 9 vorgegeben ist. Entlang des Transportweges 7 sind Leiterplatten 4 in Transportrichtung 27 bewegbar und dem Druckspalt 8 zuführbar.

Die unterhalb des Transportweges 7 angeordnete Siebdrucktrommel 6 ist mittels einer Höhenverstelleinrichtung 13 anheb- und absenkbar. In der Anhebestellung 25 bildet die Siebdrucktrommel 6 mit der anderen Siebdrucktrommel 5 den Druckspalt 8, während sie in ihrer Absenkstellung 26 maximal vom Transportweg 7 entfernt ist. Die Höhenverstelleinrichtung 13 weist eine Höhenanzeigevorrichtung 14 in Form beispielsweise einer Skala auf und einen Antrieb 15 auf. Durch diesen ist die Siebdrucktrommel 6 entlang der Höhenanzeigeeinrichtung 14 beispielsweise durch ein mit einem Motor als Antrieb verbundenes Zahnrad 30 entlang einer entsprechenden Zahnstange 31 als beispielsweise Teil der Höhenanzeigerichtung 14 verstellbar.

Entlang des Transportweges 7 ist eine Andrückeinrichtung 11 aus einer Anzahl von verschwenkbar gelagerten Andrückrollen 12 angeordnet. Die Andrückrollen sind von oben auf eine Plattenoberseite 2 anlegbar. Die Leiterplatten 4 werden in den Druckspalt 8 mittels der Transporteinrichtung 9 eingeführt und durch die beiden Siebdrucktrommeln 5, 6 gleichzeitig und synchron auf ihrer Plattenoberseite 2 und Unterseite 3 beispielsweise mit einem Lötstopp-Lack bedruckt.

Die Auftragsvorrichtung weist weiterhin eine Steuerelektronik 20 auf, die zumindest einen Mikroprozessor und eine Speichereinrichtung sowie entsprechende Betätigungs- und Anzeigeinstrumente zur Betätigung und Überprüfung der Auftragsvorrichtung enthält.

In Fig. 2 ist eine Draufsicht auf die Auftragsvorrichtung nach Fig. 1 dargestellt, wobei zur Vereinfachung die obere Siebdrucktrommel 5 mit ihrer Halterung 21 weggelassen ist. Gleiche Teile sind mit gleichen Bezugszeichen versehen und werden nur noch teilweise erwähnt.

Die Leiterplatten in Transportrichtung 25 der Auftragsvorrichtung 1 zuführenden oder abführenden, weiteren Transporteinrichtungen sind zur Vereinfachung nicht dargestellt, ebenso wie eine zusätzlich in Transportrichtung hinter den Siebdrucktrommeln 5, 6 anordbare Heizeinrichtung zum Trocknen des Lötstopp-Lacks.

Einseitig zur Halterung 21 der Siebdrucktrommel 6 wie auch der nicht dargestellten Siebdrucktrommel 5 ist am Vorrichtungsrahmen 19 eine Antriebseinrichtung 16 für beide Siebdrucktrommeln angeordnet. Die Antriebseinrichtung 16 umfaßt zumindest einen Antriebsmotor 17 und einen Geschwindigkeitsregler 18. Letzerer dient gleichzeitig zur Synchronisierung der Geschwindigkeiten beider Siebdrucktrommeln 5, 6. Die Drehübertragung von einer Siebdrucktrommel zur anderen kann über einen Riemenantrieb erfolgen, wobei beiden Siebdrucktrommeln entsprechende Riemenscheiben auf deren Drehachsen 32 zugeordnet sind.

Von der Halterung 21 der unteren Siebdrucktrommel 6 sind insbesondere zwei Haltestäbe 28 und eine Halteplatte 29 sichtbar. Die Halteplatte 29 ist mittels der Haltestäbe 28 mit der Antriebseinrichtung 16 auf der anderen Seite der Siebdrucktrommel 6 verbunden. Durch die Halteplatte 29 und die Antriebseinrichtung 16 ist die Siebdrucktrommel beidseitig drehbar gelagert.

Zur Vereinfachung ist eine entsprechende Spende- und Auftragsvorrichtung im Inneren der Siebdrucktrommel weggelassen, durch die beispielsweise Lötstopp-Lack entlang des Innenumfangs auf eine Innenseite einer Matrize der Siebdrucktrommel mengenmäßig dosiert auftragbar ist.

Die Transporteinrichtung 9 weist nach Fig. 2 eine Reihe von Transportbändern 10 auf, die zumindest schmale Randbereiche der Leiterplatten 4 parallel zur Transportrichtung 27 abstützen. Die Transportbänder können zur Anpassung an unterschiedliche Abmessungen von Leiterplatten senkrecht zur Transportrichtung 27 ebenfalls senkrecht zur Transportrichtung verstellbar gelagert sein.

## Patentansprüche

1. Auftragsvorrichtung (1) zum Auftragen von zumindest Lötstopp-Lack auf beide, insbesondere mit strukturierten Leiterbahnen versehene Seiten (2,3) einer Leiterplatte (4) mit wenigstens zwei jeweils einer Plattenseite (2,3) zuordbaren und drehbar gelagerten Auftragskörpem (5,6), **dadurch gekennzeichnet, daß** die Auftragskörper (5,6) zwei beidseitig zu einem im wesentlichen horizontalen Transportweg (7) der Leiterplatte (4) angeordnete Siebdrucktrommeln sind, wobei eine Transporteinrichtung (9) Transportbänder (10) entlang des Transportweges (7) zum Transport der Leiterplatte aufweist und die Transporteinrichtung (9) weiterhin auf einer Plattenseite (2) aufdrückbare Andrückeinrichtung (11) zum Halten der Leiterplatte auf den Transportbändern (10) aufweist.

2. Auftragsvorrichtung nach Anspruch 1, **dadurch gekennzeichnet, daß** wenigstens eine Siebdrucktrommel (5,6) im wesentlichen senkrecht zum Transportweg (7) verstellbar gelagert ist.

3. Auftragsvorrichtung nach Anspruch 1 der 2, **dadurch gekennzeichnet, daß** dem Transportweg (7) die zumindest einen Randbereich und/oder Rand der Leiterplatte (4) abstützende und/oder haltende Transporteinrichtung (9) zugeordnet ist.

4. Auftragsvorrichtung nach wenigstens einem der vorangegangenen Ansprüche, **dadurch gekennzeichnet, daß** die Andrückeinrichtungen (11) Andrückrollen (12) aufweisen.

5. Auftragsvorrichtung nach wenigstens einem der vorangehenden Ansprüche, **dadurch gekennzeichnet, daß** die Andrückrollen (12) verschwenkbar gelagert sind.

6. Auftragsvorrichtung nach wenigstens einem der vorangehenden Ansprüche, **dadurch gekennzeichnet, daß** mehrere Transportwege (7) für Leiterplatten (4) nebeneinander zur parallelen Zufuhr von Leiterplatten zu den Siebdrucktrommeln (5,6) angeordnet sind.

7. Auftragsvorrichtung nach wenigstens einem der vorangehenden Ansprüche, **dadurch gekennzeichnet, daß** eine Höhenverstelleinrichtung (13) der verstellbar gelagerten Siebdrucktrommel (5,6) zur automatischen Höhenverstellung zugeordnet ist.

8. Auftragsvorrichtung nach wenigstens einem der vorangehenden Ansprüche, **dadurch gekennzeichnet, daß** die Höhenversteileinrichtung (13) eine Höhenanzeigeeinrichtung (14) und einen Antrieb (15) zum Anheben und Absenken der Siebdrucktrommel (5,6) aufweist.

9. Auftragsvorrichtung nach wenigstens einem der vorangehenden Ansprüche, **dadurch gekennzeichnet, daß** beiden Siebdrucktrommeln (5,6) eine Antriebseinrichtung (16) zugeordnet ist.

10. Auftragsvorrichtung nach wenigstens einem der vorangehenden Ansprüche, **dadurch gekennzeichnet, daß** die Antriebseinrichtung (16) einen Motor (17) und einen Geschwindigkeitsregler (18) insbesondere zur Synchronisierung der Drehungen der Siebdrucktrommeln (5,6) aufweist.

11. Auftragsvorrichtung nach wenigstens einem der vorangehenden Ansprüche, **dadurch gekennzeichnet, daß** die Siebdrucktrommeln austauschbar in der Auftragsvorrichtung (1) gelagert sind.

12. Auftragsvorrichtung nach wenigstens einem der vorangehenden Ansprüche, **dadurch gekennzeichnet, daß** die Auftragsvorrichtung (1) eine Steuerelektronik (20) mit zumindest einem Mikroprozessor und einer Speichereinrichtung aufweist.

13. Auftragsvorrichtung nach wenigstens einem der vorangehenden Ansprüche, **dadurch gekennzeichnet, daß** jede Siebdrucktrommel (5,6) in einer Halterung (21) drehbar gelagert ist, an welcher eine einem Innenumfang (22) der Siebdrucktrommel (5,6) zuordbare Spende- und Auftragseinrichtung verstellbar gelagert ist.

## Claims

1. An application device (1) for applying at least a solder resist onto both surfaces (2, 3) of a printed circuit board (4) that are in particular provided with structurized printed conductors, the application device comprising at least two application bodies (5, 6) that can be assigned to the corresponding surface (2, 3) of the board and are rotatably supported, **characterized in that** the application bodies (5, 6) are two screen printing drums arranged on both sides of an essentially horizontal transport path (7) of the printed circuit board (4), wherein a transport means (9) comprises conveyor belts (10) along the transport path (7) for transporting the printed circuit board, and the transport means (9) further comprises pressing means (11) that can be pressed onto a surface (2) of the board for holding the printed circuit board on the conveyor belts (10).

2. The application device according to claim 1, **characterized in that** at least one screen printing drum (5, 6) is adjustably supported essentially in a direction perpendicular to the transport path (7).

3. The application device according to claim 1 or 2, **characterized in that** the transport path (7) has assigned thereto the transport means (9) which supports and/or holds at least an edge portion and/or edge of the printed circuit board (4).

4. The application device according to at least one of the preceding claims,
**characterized in that** the pressing means (11) comprises pressing rolls (12).

5. The application device according to at least one of the preceding claims,
**characterized in that** the pressing rolls (12) are pivotably supported.

6. The application device according to at least one of the preceding claims,
**characterized in that** a plurality of transport paths (7) for printed circuit boards (4) are arranged side by side for the parallel supply of printed circuit boards to the screen printing drums (5, 6).

7. The application device according to at least one of the preceding claims,
**characterized in that** a height adjusting means (13) is assigned to the adjustably supported screen printing drum (5, 6) for automatically adjusting the height.

8. The application device according to at least one of the preceding claims,
**characterized in that** the height adjusting means (13) comprises a height indicating means (14) and a drive (15) for lifting and lowering the screen printing drum (5, 6).

9. The application device according to at least one of the preceding claims,
**characterized in that** both screen printing drums (5, 6) have assigned thereto a drive means (16).

10. The application device according to at least one of the preceding claims,
**characterized in that** the drive means (16) comprises a motor (17) and a speed controller (18), in particular for synchronizing the rotations of the screen printing drums (5, 6).

11. The application device according to at least one of the preceding claims,
**characterized in that** the screen printing drums are replaceably supported in the application device (1).

12. The application device according to at least one of the preceding claims,
**characterized in that** the application device (1) comprises an electronic control unit (20) including at least one microprocessor and a storing means.

13. The application device according to at least one of the preceding claims,
**characterized in that** each screen printing drum (5, 6) is rotatably supported in a holding device (21) which has adjustably supported thereon a dispenser and application means that can be assigned to an inner circumference (22) of the screen printing drum (5, 6).

## Revendications

1. Dispositif d'application (1) pour appliquer au moins un vernis de réserve de soudure sur les deux côtés (2,3), pourvus notamment de pistes conductives structurées, d'une plaquette à circuit imprimé (4), comprenant au moins deux corps d'application (5, 6) aptes à être associés aux côtés respectifs (2, 3) de la plaquette et montés rotatifs, **caractérisé en ce que** les corps d'application (5, 6) sont constitués par deux tambours de sérigraphie disposés de part et d'autre d'une voie de transport globalement horizontale (7) de la plaquette (4), un dispositif de transport (9) comportant des bandes de transport (10) le long de la voie de transport (7), pour le transport de la plaquette, et ce dispositif de transport (9) comportant également un dispositif presseur (11) apte à être appliqué sur un côté (2) de la plaquette pour maintenir celle-ci sur les bandes de transport (10).

2. Dispositif d'application selon la revendication 1, **caractérisé en ce qu'**au moins un tambour de sérigraphie (5, 6) est monté pour pouvoir être déplacé globalement perpendiculairement au sens de transport (7).

3. Dispositif d'application selon la revendication 1 ou 2, **caractérisé en ce que** le dispositif de transport (9) qui supporte et/ou retient au moins une zone extérieure et/ou un bord de la plaquette à circuit imprimé (4) est associé à la voie de transport (7).

4. Dispositif d'application selon l'une au moins des revendications précédentes, **caractérisé en ce que** les dispositifs presseurs (11) comportent des rouleaux presseurs (12).

5. Dispositif d'application selon l'une au moins des revendications précédentes, **caractérisé en ce que** les rouleaux presseurs (12) sont montés pivotants.

6. Dispositif d'application selon l'une au moins des revendications précédentes, **caractérisé en ce que** plusieurs voies de transport (7) pour les plaquettes à circuit imprimé (4) sont disposées côte à côte afin d'amener des plaquettes parallèlement jusqu'aux tambours de sérigraphie (5, 6).

7. Dispositif d'application selon l'une au moins des revendications précédentes, **caractérisé en ce qu'**un dispositif de réglage en hauteur (13) est associé au tambour de sérigraphie réglable (5, 6), en vue d'un réglage en hauteur automatique.

8. Dispositif d'application selon l'une au moins des revendications précédentes, **caractérisé en ce que** le dispositif de réglage en hauteur (13) comporte un dispositif d'indication de hauteur (14) et un entraînement (15) pour soulever et abaisser le tambour de sérigraphie (5, 6) .

9. Dispositif d'application selon l'une au moins des revendications précédentes, **caractérisé en ce qu'**un dispositif d'entraînement (16) est associé aux deux tambours de sérigraphie (5, 6).

10. Dispositif d'application selon l'une au moins des revendications précédentes, **caractérisé en ce que** le dispositif d'entraînement (16) comporte un moteur (17) et un régulateur de vitesse (18) en particulier pour synchroniser les rotations des tambours de sérigraphie (5, 6).

11. Dispositif d'application selon l'une au moins des revendications précédentes, **caractérisé en ce que** les tambours de sérigraphie sont montés dans le dispositif d'application (1) de manière à pouvoir être changés.

12. Dispositif d'application selon l'une au moins des revendications précédentes, **caractérisé en ce qu'**il comporte un système électronique de commande (20) avec au moins un microprocesseur et un dispositif de mémoire.

13. Dispositif d'application selon l'une au moins des revendications précédentes, **caractérisé en ce que** chaque tambour de sérigraphie (5, 6) est monté rotatif dans une fixation (21) sur laquelle un dispositif de distribution et d'application apte à être associé à une circonférence intérieure (22) du tambour de sérigraphie (5, 6) est monté pour être réglable.
